# DEMANDE DE BREVET EUROPEEN

(11) **EP 4 716 417 A1**
(43) Date de publication de la demande: **25.03.2026**
(21) Numéro de dépôt: 25202717.2
(22) Date de dépôt: 17.09.2025
(51) Int. Cl.: H10F 19/80, H10F 19/85

(54) **PROCÉDÉ DE RÉALISATION D'UNE STRUCTURE PHOTOVOLTAÏQUE DÉFINISSANT UN MODULE PRÉCURSEUR**

(30) Priorité: 23.09.2024 FR 2410109
(71) Demandeur: Commissariat à l'Energie Atomique et aux Energies Alternatives, 75015 Paris (FR)
(72) Inventeur: CARIOU, Romain, 38054 GRENOBLE CEDEX 09 (FR); JAMIN, Clément, 38054 GRENOBLE CEDEX 09 (FR); CHARPENTIER, Jean-Baptiste, 38054 GRENOBLE CEDEX 09 (FR); VOARINO, Philippe, 38054 GRENOBLE CEDEX 09 (FR)
(74) Mandataire: Regimbeau

(57) **Abrégé**

L'invention concerne un procédé de réalisation d'une structure photovoltaïque, définissant un module précurseur, à partir d'un premier empilement comportant : une pluralité de cellules photovoltaïques disposées côte à côte et reliées électriquement entre elles par des conducteurs de liaison, formant la face avant de la structure photovoltaïque ; une première couche de matériau d'encapsulation ; une première couche barrière, formant la face arrière de la structure photovoltaïque. La première couche de matériau d'encapsulation est située entre la pluralité de cellules photovoltaïques et la première couche barrière, et le procédé se caractérise en ce qu'il comporte une première étape de lamination à chaud des couches constitutives du premier empilement au moyen d'un dispositif de lamination, au cours de laquelle le dispositif de lamination est au contact direct des cellules photovoltaïques.

## Description

### DOMAINE TECHNIQUE DE L'INVENTION

La présente invention se rapporte au domaine général des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin.

En particulier, l'invention se rapporte au domaine de la fabrication des modules photovoltaïques par le biais de la lamination à chaud.

L'invention concerne le domaine des modules photovoltaïques utilisés pour des applications terrestres, atmosphériques, notamment stratosphériques, et/ou des applications spatiales, étant particulièrement concernée par les applications qui requièrent l'utilisation de modules photovoltaïques légers et rigides, en particulier d'un poids par unité de surface inférieur à 6 kg/m², voire 5 kg/m².

L'invention concerne ainsi un procédé de réalisation d'une structure photovoltaïque définissant un module précurseur, ainsi qu'un procédé de réalisation d'un module photovoltaïque à partir d'un tel module précurseur.

### ÉTAT DE LA TECHNIQUE

Un module photovoltaïque est un assemblage de cellules photovoltaïques disposées côte à côte entre une première couche transparente formant une face du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux. Elle est traditionnellement réalisée en une seule plaque de verre, notamment du verre trempé, présentant une épaisseur typiquement comprise entre 2 mm et 4 mm, classiquement de l'ordre de 3 mm. Elle peut également être réalisée en polymère ou en composite, par exemple en fibres de verre.

La deuxième couche formant la face arrière du module photovoltaïque peut quant à elle être réalisée à base de verre, de métal ou de polymère, entre autres. Elle est souvent formée par une structure polymérique à base d'un polymère isolant électrique, par exemple du type polytéréphtalate d'éthylène (PET) ou polyamide (PA), pouvant être protégée par une ou des couches à base de polymères fluorés, comme le polyfluorure de vinyle (PVF) ou le polyfluorure de vinylidène (PVDF), et ayant une épaisseur de l'ordre de 400 µm. Elle peut encore être en composite, par exemple en fibres de verre.

Les cellules photovoltaïques, qui se présentent sous forme de fines plaques d'épaisseur comprise entre 20 µm et 200 µm, par exemple d'environ 180 µm, peuvent être reliées électriquement entre elles (interconnectées) par des éléments de contact électrique avant et arrière, appelés conducteurs de liaison, et formés par exemple par des bandes (ou rubans) ou fils de cuivre étamé, notamment respectivement disposées contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques, ou bien encore uniquement en face arrière pour les cellules photovoltaïques de type IBC (pour « Interdigitated Back Contact » en anglais).

Par ailleurs, les cellules photovoltaïques, situées entre les première et deuxième couches formant respectivement les faces avant et arrière du module photovoltaïque, peuvent être encapsulées. De façon classique, l'encapsulant choisi correspond à un polymère du type élastomère (ou caoutchouc), et peut par exemple consister en l'utilisation de deux couches (ou films) de poly(éthylène-acétate de vinyle) (EVA) entre lesquelles sont disposées les cellules photovoltaïques et les conducteurs de liaison des cellules.

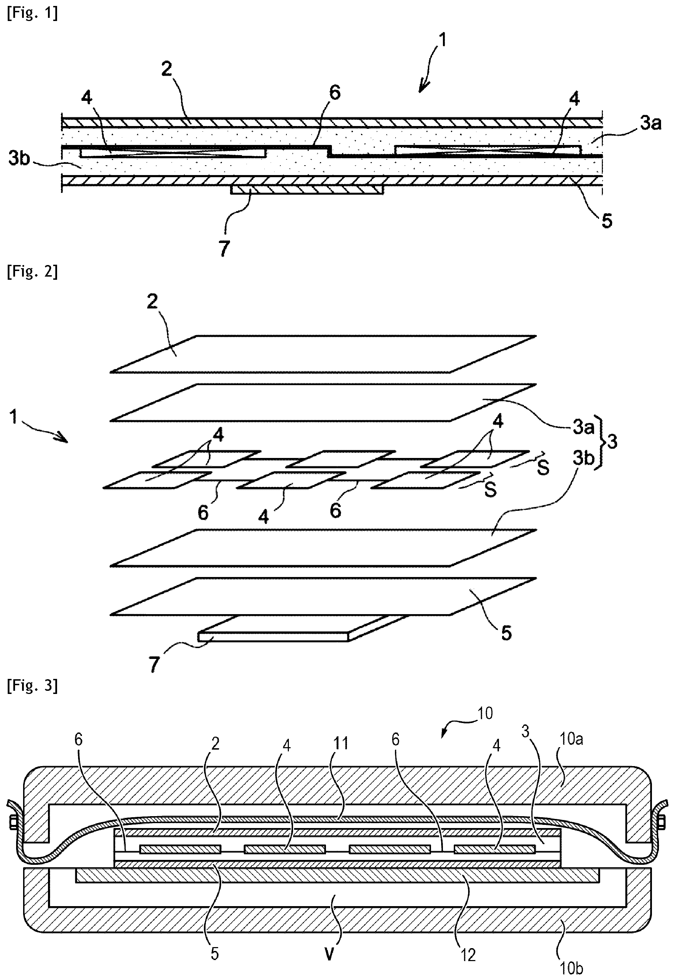

On a ainsi représenté partiellement et schématiquement, respectivement en coupe sur la figure 1 et en vue éclatée sur la figure 2, un exemple classique de module photovoltaïque 1 comportant des cellules photovoltaïques 4 cristallines.

Comme décrit précédemment, le module photovoltaïque 1 comporte une face avant 2, généralement réalisée en verre trempé transparent d'épaisseur d'environ 3 mm, et une face arrière 5, par exemple constituée par une feuille polymère, opaque ou transparente, monocouche ou multicouche. Entre les faces avant 2 et arrière 5 du module photovoltaïque 1 se situent les cellules photovoltaïques 4, reliées électriquement entre elles par des conducteurs de liaison 6 et immergées entre deux couches avant 3a et arrière 3b de matériau d'encapsulation formant toutes les deux un ensemble encapsulant 3. Par ailleurs, les figures 1 et 2 représentent également la boîte de jonction 7 du module photovoltaïque 1, destinée à recevoir le câblage nécessaire à l'exploitation du module photovoltaïque 1 et raccordant les bandes de cuivre du circuit de cellules photovoltaïques 4. Enfin, bien que non représenté sur les figures 1 et 2, un cadre en aluminium, ou autre matériau, peut être prévu autour de l'ensemble des couches décrites auparavant pour finaliser le module photovoltaïque 1.

Ainsi, un module photovoltaïque 1 comprend une multitude de cellules photovoltaïques 4, identiques et connectées en série et/ou en parallèle afin de fournir en sortie la tension et/ou le courant requis pour alimenter des dispositifs électriques. Le format de module le plus courant emploie 60 cellules carrées, ou « pseudo-carrées », de 156 mm de côté, réparties en six chaînes ou séries S, comme visible sur la figure 2, appelées encore « strings » en anglais, de dix cellules interconnectées en série. Les six chaînes S de cellules photovoltaïques 4 sont également interconnectées en série.

L'intégrité du module photovoltaïque 1 est typiquement assurée par un procédé dit de lamination, comprenant une séquence d'étapes (pompage, chauffage, pression) avec des températures et des pressions variables, qui a pour but de solidariser de manière durable l'ensemble des couches constitutives du module et de leur fournir une résistance à leurs environnements applicatifs pendant plusieurs années, voire plusieurs dizaines d'années. La lamination a donc pour vocation de fournir l'enveloppe protectrice des cellules photovoltaïques.

Ainsi, de façon habituelle, le procédé de réalisation du module photovoltaïque 1 comporte une étape de lamination sous vide des différentes couches décrites précédemment, à une température supérieure ou égale à 120°C, voire 140°C, voire encore 150° C, et inférieure ou égale à 170°C, typiquement comprise entre 145 et 165 ° C, et pendant une durée du cycle de lamination généralement d'au moins 10 minutes, voire entre 15 et 20 minutes.

Pendant cette étape de lamination, les couches de matériau d'encapsulation 3a et 3b fondent et viennent englober les cellules photovoltaïques 4, en même temps que l'adhérence se crée à toutes les interfaces entre les couches, à savoir entre la face avant 2 et la couche avant de matériau d'encapsulation 3a, la couche avant de matériau d'encapsulation 3a et les faces avant 4a des cellules photovoltaïques 4, les faces arrière 4b des cellules photovoltaïques 4 et la couche arrière de matériau d'encapsulation 3b, et la couche arrière de matériau d'encapsulation 3b et la face arrière 5 du module photovoltaïque 1. Le module photovoltaïque 1 obtenu peut ensuite être encadré, typiquement par le biais d'un profilé en aluminium, voire un autre matériau.

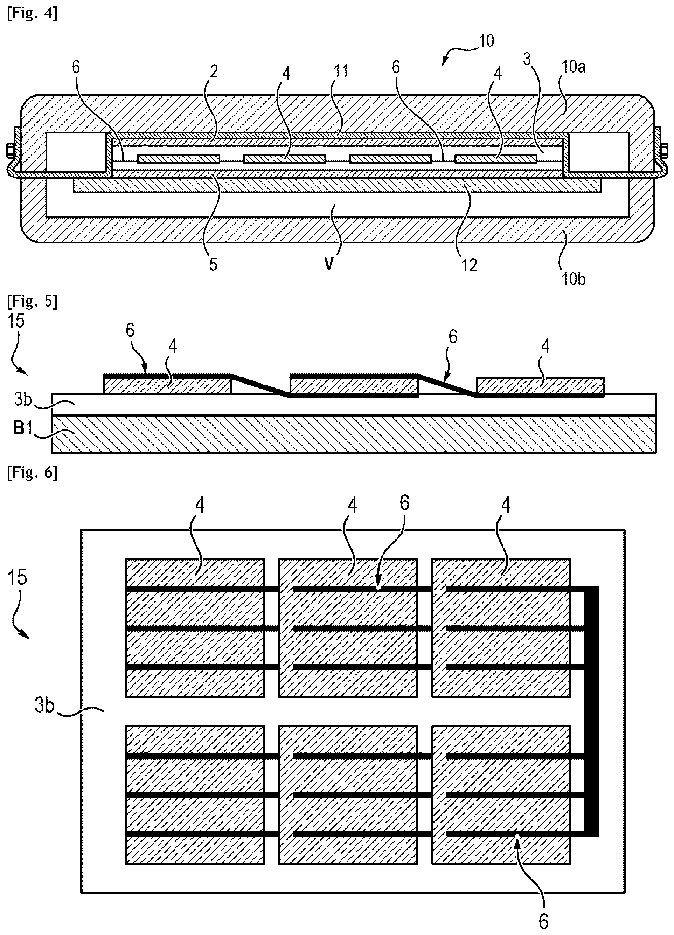

Les figures 3 et 4 ci-dessous sont des schémas en coupe typiques illustrant un empilement d'un module photovoltaïque 1 respectivement avant et pendant l'étape de lamination.

Comme visible sur la figure 3, les couches constitutives de l'empilement destiné à former le module photovoltaïque 1 sont placées dans un dispositif de lamination 10, entre la partie supérieure de lamination 10a et la partie inférieure de lamination 10b du dispositif de lamination 10. La partie inférieure de lamination 10b comporte au moins une plaque de chauffage 12, ou plateau chauffant, située au-dessus d'une zone de vide V. Une membrane 11 est par ailleurs solidarisée à la partie supérieure de lamination 10a et vient se placer au-dessus de l'empilement.

L'air est évacué au travers d'une pompe à vide et la membrane 11 est ainsi plaquée contre l'empilement afin de consolider celui-ci et de permettre l'interpénétration des couches constitutives du module photovoltaïque 1, comme visible sur la figure 4.

Lors de ce procédé de lamination, l'ensemble des matériaux de l'empilement du module photovoltaïque 1 atteint la même température, le chauffage étant assuré par conduction par la ou les plaques de chauffage 12. Ainsi, la température de lamination restreint de facto le choix et la diversité des matériaux du module photovoltaïque 1. Par exemple, l'utilisation d'une seule lamination pour un empilement contenant des adhésifs à des températures de mise en œuvre différentes, notamment des films de poly(éthylène-acétate de vinyle) (EVA) et de la silicone liquide, conduit à l'obtention de bulles post-lamination dans les adhésifs et/ou aux interfaces, ce qui est délétère pour la durabilité des modules photovoltaïques. De plus, la conception symétrique du module photovoltaïque, de part et d'autre des cellules photovoltaïques, engendre un poids non nécessairement souhaité pour le module photovoltaïque, parfois trop important pour certaines applications.

Il existe donc un besoin pour permettre de modifier le principe de fabrication usuel par lamination afin d'élargir la gamme des matériaux, et donc des propriétés, accessibles pour l'obtention d'un module photovoltaïque. Il existe également un besoin pour obtenir un gain en masse lors de la fabrication d'un module photovoltaïque afin d'élargir le spectre d'utilisation à des domaines variés.

En effet, les faces avant et arrière des modules photovoltaïques ne présentent pas, le plus souvent, les mêmes spécifications en termes optique, mécanique, thermique, etc. Cependant, l'assemblage d'un module photovoltaïque se fait systématiquement en une seule étape pour ces deux faces, généralement de manière symétrique, ce qui réduit les possibilités et conduit bien souvent à l'obtention d'une solution sous-optimale en termes de matériaux et procédés répondant aux spécifications de ces faces.

### EXPOSÉ DE L'INVENTION

L'invention a pour but de remédier au moins partiellement aux besoins mentionnés ci-dessus et aux inconvénients relatifs aux réalisations de l'art antérieur.

L'invention a ainsi pour objet, selon l'un de ses aspects, un procédé de réalisation d'une structure photovoltaïque, définissant un module précurseur, à partir d'un premier empilement comportant :
- une pluralité de cellules photovoltaïques disposées côte à côte et reliées électriquement entre elles par des conducteurs de liaison, formant la face avant de la structure photovoltaïque,
- une première couche de matériau d'encapsulation,
- une première couche barrière, formant la face arrière de la structure photovoltaïque,

la première couche de matériau d'encapsulation étant située entre la pluralité de cellules photovoltaïques et la première couche barrière,
caractérisé en ce que le procédé comporte une première étape de lamination à chaud des couches constitutives du premier empilement au moyen d'un dispositif de lamination, au cours de laquelle le dispositif de lamination est au contact direct des cellules photovoltaïques.

Il est à noter que les notions de « face avant de la structure photovoltaïque » et de « face arrière de la structure photovoltaïque » sont indépendantes des notions de « face avant du module photovoltaïque » et de « face arrière du module photovoltaïque ». En particulier, la « face avant de la structure photovoltaïque » peut être ou non du même côté que la « face avant du module photovoltaïque » par rapport aux cellules photovoltaïques. De même, la « face arrière de la structure photovoltaïque » peut être ou non du même côté que la « face arrière du module photovoltaïque » par rapport aux cellules photovoltaïques.

Le procédé de réalisation selon l'invention peut en outre comporter l'une ou plusieurs des caractéristiques suivantes prises isolément ou suivant toutes combinaisons techniques possibles.

Les cellules photovoltaïques peuvent être de tout type. Elles sont avantageusement des cellules photovoltaïques cristallines, c'est-à-dire qui sont à base de silicium monocristallin ou multicristallin.

Les cellules photovoltaïques peuvent être des cellules à contact face arrière, ou des configurations de type « flip/flop » (« retourné »), c'est-à-dire avec une interconnexion de cellules consécutives bifaciales (face avant à face avant, puis face arrière à face arrière), ou de type « shingle » (« tuile »), c'est-à-dire avec une interconnexion de cellules par recouvrement partiel), ou de type « tilling/paving » (« carrelage/pavage »), c'est-à-dire avec une interconnexion de cellules avec espacement réduit, ou de type IBC (pour « Interdigitated Back Contacts » en anglais), entre autres.

L'espacement entre deux cellules photovoltaïques voisines, ou encore consécutives ou adjacentes, peut dans certaines configurations être supérieur ou égal à 1 mm, notamment compris entre 1 mm et 30 mm, et de préférence égal à 2 mm. Dans d'autres configurations, notamment de type « shingle » selon l'appellation anglaise (« tuile » ou « bardeau » en français), les cellules photovoltaïques voisines, ou encore consécutives ou adjacentes, peuvent se chevaucher ou et donc avoir un espacement inférieur à 1 mm.

En outre, les cellules photovoltaïques peuvent présenter une épaisseur comprise entre 20 µm et 300 µm.

Par ailleurs, le dispositif de lamination peut être tel que décrit précédemment en référence aux figure 3 et 4. En particulier, le dispositif de lamination peut comporter une membrane venant au contact direct des cellules photovoltaïques lors de la première étape de lamination à chaud.

La première étape de lamination à chaud peut être réalisée à une température comprise entre 60°C et 180°C, notamment comprise entre 120°C et 170°C. En particulier, le dispositif de lamination peut comporter au moins une plaque de chauffage à une température comprise entre 60°C et 180°C, notamment comprise entre 120°C et 170°C. La durée du cycle de lamination peut être d'au moins 5 minutes, préférentiellement entre 10 minutes et 20 minutes.

En outre, selon une première variante, la première couche de matériau d'encapsulation peut recouvrir totalement la surface de la première couche barrière.

Selon une deuxième variante, la première couche de matériau d'encapsulation peut recouvrir partiellement la surface de la première couche barrière, recouvrant notamment uniquement les zones de la surface de la première couche barrière superposées aux cellules photovoltaïques et/ou aux conducteurs de liaison et/ou aux autres éléments d'interconnexion, tels que des diodes bypass.

De plus, le premier empilement peut comporter, le cas échéant, une première couche de renfort située entre la première couche barrière et la première couche de matériau d'encapsulation, notamment une première couche de renfort composite.

La première couche de renfort composite peut présenter une densité massique comprise entre 20 g/m² et 500 g/m². Elle peut comporter une matrice thermodurcissable ou thermoplastique, ou encore un verre époxy.

Par ailleurs, l'invention a aussi pour objet, selon un autre de ses aspects, un procédé de réalisation d'un module photovoltaïque à partir d'un deuxième empilement comportant :
- une deuxième couche de matériau d'encapsulation,
- une structure photovoltaïque obtenue par le procédé de réalisation tel que défini précédemment,
caractérisé en ce que le procédé comporte une deuxième étape d'assemblage à chaud des couches constitutives du deuxième empilement.

Selon une première variante, la deuxième couche de matériau d'encapsulation peut former l'une d'une couche avant transparente formant la face avant du module photovoltaïque, destinée à recevoir un flux lumineux, et d'une couche arrière, pouvant être également transparente, et destinée à recevoir un flux lumineux, formant la face arrière du module photovoltaïque, et la première couche barrière peut former l'autre de ladite couche avant et de ladite couche arrière.

Selon une deuxième variante, le deuxième empilement peut comporter encore une deuxième couche barrière, la deuxième couche de matériau d'encapsulation étant située entre la deuxième couche barrière et la structure photovoltaïque. La deuxième couche barrière peut alors former l'une d'une couche avant transparente formant la face avant du module photovoltaïque, destinée à recevoir un flux lumineux, et d'une couche arrière, pouvant être également transparente, et destinée à recevoir un flux lumineux, formant la face arrière du module photovoltaïque, et la première couche barrière peut former l'autre de ladite couche avant et de ladite couche arrière.

Par ailleurs, la deuxième couche de matériau d'encapsulation peut former une couche avant de matériau d'encapsulation et la première couche de matériau d'encapsulation peut former une couche arrière de matériau d'encapsulation, réunies entre elles pour définir un ensemble encapsulant la pluralité de cellules photovoltaïques.

La deuxième couche de matériau d'encapsulation et/ou la deuxième couche barrière peut, le cas échéant, recouvrir partiellement la surface de la structure photovoltaïque, et peut en particulier ne pas recouvrir les cellules photovoltaïques, et notamment recouvrir uniquement les conducteurs de liaison et/ou d'autres éléments d'interconnexion, par exemple situés en périphérie.

La deuxième étape d'assemblage à chaud peut correspondre à une deuxième étape de traitement thermique pour solidariser les couches constitutives du deuxième empilement. Elle peut correspondre à une deuxième étape d'encapsulation partielle, notamment d'encapsulation du côté des cellules photovoltaïques non encapsulées lors de la première étape de lamination qui, elle, correspond alors à une première étape d'encapsulation partielle.

La deuxième étape d'assemblage à chaud peut comporter au moins une deuxième étape de lamination, d'évaporation, d'impression, de vaporisation (ou « spray » en anglais), de raclage, d'enduction centrifuge (ou « spin coating » en anglais) et/ou de thermocompression, entre autres. La deuxième étape d'assemblage à chaud peut être réalisée par dépôt de film ou de matière. La deuxième étape d'assemblage à chaud peut être mise en œuvre à une température strictement supérieure à 0°C. La deuxième étape d'assemblage à chaud peut être réalisée avec ou sans variation de pression.

Préférentiellement, la deuxième étape d'assemblage à chaud peut comporter une deuxième étape de lamination à chaud.

La deuxième étape d'assemblage à chaud peut être réalisée à température ambiante.

La deuxième étape d'assemblage à chaud peut encore être réalisée à une température à une température inférieure à la température de la première étape de lamination minorée de 30°C, notamment comprise entre 50°C et 100°C. En particulier, lorsque la deuxième étape d'assemblage à chaud comporte une deuxième étape de lamination à chaud, le dispositif de lamination peut comporter au moins une plaque de chauffage à une température comprise entre 50°C et 100° C. La durée du cycle de lamination peut être d'au moins 5 minutes, et préférentiellement entre 10 minutes et 20 minutes.

En outre, selon une première variante, la deuxième couche de matériau d'encapsulation peut recouvrir totalement la surface de la première couche barrière.

Selon une deuxième variante, la deuxième couche de matériau d'encapsulation peut recouvrir partiellement la surface de la première couche barrière, recouvrant notamment uniquement les zones de la surface de la première couche barrière superposées aux cellules photovoltaïques et/ou aux conducteurs de liaison et/ou aux autres éléments d'interconnexion, tels que des diodes bypass.

Le deuxième empilement peut, le cas échéant, comporter une deuxième couche de renfort située entre la deuxième couche barrière et la deuxième couche de matériau d'encapsulation, notamment une deuxième couche de renfort composite.

La deuxième couche de renfort composite peut présenter une densité massique comprise entre 20 g/m² et 500 g/m². Elle peut comporter une matrice thermodurcissable ou thermoplastique, ou encore un verre époxy.

De plus, un primaire d'adhésion peut être ajouté au contact de la deuxième couche de matériau d'encapsulation, notamment de part et d'autre de la deuxième couche de matériau d'encapsulation.

Par ailleurs, la première couche de matériau d'encapsulation et/ou la deuxième couche de matériau d'encapsulation, et de façon préférentielle la première couche de matériau d'encapsulation, peuvent être formées par au moins une couche comportant au moins un matériau d'encapsulation de type polymère choisi parmi : les copolymères d'acides, les ionomères, le poly(éthylène-acétate de vinyle) (EVA), les acétals de vinyle, tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'α-oléfines et des α-, β- esters d'acide carboxylique à éthylénique, tels que les copolymères éthylène-acrylate de méthyle et les copolymères éthylène-acrylate de butyle, les élastomères de silicone et/ou les élastomères à base de polyoléfine thermoplastique réticulée.

En outre, la première couche de matériau d'encapsulation et/ou la deuxième couche de matériau d'encapsulation, et de façon préférentielle la deuxième couche de matériau d'encapsulation, peuvent comporter du silicone liquide et/ou un film adhésif.

La première couche de matériau d'encapsulation et/ou la deuxième couche de matériau d'encapsulation peuvent présenter une épaisseur comprise entre 12 µm et 900 µm, notamment entre 25 µm et 900 µm.

De plus, la première couche barrière et/ou la deuxième couche barrière peuvent présenter présentent une épaisseur comprise entre 12 µm et 6 cm.

La première couche barrière et/ou la deuxième couche barrière peuvent être transparentes, notamment aux longueurs d'ondes comprises entre 250 nm et 1800 nm, notamment entre 300 nm et 1200 nm.

Par ailleurs, la première couche barrière et/ou la deuxième couche barrière peuvent comporter un panneau en matériau composite, du verre, un matériau polymère et/ou un matériau composite à base de verre et de matériau polymère.

En particulier, la première couche barrière et/ou la deuxième couche barrière peuvent comporter un panneau en matériau composite, ce panneau formant une structure sandwich. Le panneau peut comporter une sous-couche principale, formant l'âme du panneau, et deux sous-couches de recouvrement, formant chacune une plaque du panneau, disposées de part et d'autre de l'âme de sorte que l'âme soit prise en sandwich entre les deux plaques, l'âme du panneau comportant une structure alvéolaire, le panneau présentant notamment une épaisseur comprise entre 1 mm et 15 mm.

L'âme du panneau peut comporter une structure alvéolaire, par exemple sous forme de nid d'abeilles, notamment réalisée en métal, par exemple aluminium, en polyimide, en polycarbonate (PC), en polypropylène (PP) ou en fibres synthétiques hautes performances, par exemple de type Nomex^{®}, voire en carton.

En variante, l'âme du panneau peut comporter une structure alvéolaire sous forme de mousse, notamment réalisée en polytéréphtalate d'éthylène (PET), en polychlorure de vinyle (PVC) ou en polyuréthane (PU).

En outre, les plaques du panneau peuvent être réalisées en matériau composite, par exemple de type prépreg fibres de verre/époxy, en métal, notamment en aluminium, en polycarbonate (PC), en polyméthacrylate de méthyle (PMMA) ou à partir de pré-imprégnés.

Les plaques du panneau peuvent, le cas échéant, être recouvertes d'un film mono ou multicouche polymère, par exemple du type Tedlar^{®}.

De plus, le panneau peut présenter un poids surfacique inférieur ou égal à 3 kg/m², notamment inférieur ou égal à 2 kg/m², notamment encore inférieur ou égal à 1 kg/m².

Selon une autre variante, la première couche barrière et/ou la deuxième couche barrière peuvent comporter du verre, présentant notamment une épaisseur comprise entre 30 µm et 500 µm.

Selon encore une autre variante, la première couche barrière et/ou la deuxième couche barrière peuvent comporter un matériau polymère, présentant notamment une épaisseur comprise entre 12 µm et 500 µm.

Selon encore une autre variante, la première couche barrière et/ou la deuxième couche barrière peuvent comporter un matériau composite à base de verre et de matériau polymère, présentant notamment une épaisseur comprise entre 12 µm et 500 µm.

Le matériau polymère peut être choisi parmi : le polycarbonate (PC), le polyuréthane (PU), le polypropylène (PP), l'époxy, le polyimide (PI), le polyétheréthercétone (PEEK), le polyméthacrylate de méthyle (PMMA), le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), le polychlorotrifluoroéthylène (PCTFE), l'éthylène propylène fluoré (FEP) et/ou un film multicouche comprenant un ou plusieurs des polymères précités.

### BRÈVE DESCRIPTION DES FIGURES

D'autres avantages, buts et caractéristiques particulières de l'invention ressortiront de la description non limitative qui suit d'au moins un mode de mise en œuvre de la présente invention, en regard des figures annexées, sur lesquelles :
- la figure 1 représente, en coupe, un exemple classique de module photovoltaïque comportant des cellules photovoltaïques cristallines,
- la figure 2 représente, en vue éclatée, le module photovoltaïque de la figure 1,
- la figure 3 représente schématiquement, en coupe, un empilement d'un module photovoltaïque placé dans un dispositif de lamination, avant l'étape de lamination pour la réalisation du module photovoltaïque,
- la figure 4 représente schématiquement, en coupe, l'empilement de la figure 3, pendant l'étape de lamination pour la réalisation du module photovoltaïque,
- la figure 5 représente, selon une vue en coupe, un exemple de réalisation d'un module précurseur par la mise en œuvre du procédé conforme à l'invention,
- la figure 6 représente, selon une vue du dessus, le module précurseur de la figure 5,
- la figure 7 représente, selon une vue du dessus, une variante de réalisation du module précurseur de la figure 5,
- la figure 8 représente, selon une vue en coupe, un autre exemple de réalisation d'un module précurseur par la mise en œuvre du procédé conforme à l'invention,
- la figure 9 représente, selon une vue du dessus, le module précurseur de la figure 8,
- la figure 10 représente, selon une vue du dessus, une variante de réalisation du module précurseur de la figure 8,
- la figure 11 représente, selon une vue en coupe, un exemple de réalisation d'un module photovoltaïque par la mise en œuvre du procédé conforme à l'invention,
- la figure 12 représente, selon une vue du dessus, le module photovoltaïque de la figure 11,
- la figure 13 représente, selon une vue du dessus, une variante de réalisation du module photovoltaïque de la figure 11,
- la figure 14 représente, selon une vue en coupe, un autre exemple de réalisation d'un module photovoltaïque par la mise en œuvre du procédé conforme à l'invention,
- la figure 15 représente, selon une vue du dessus, le module photovoltaïque de la figure 14, et
- la figure 16 représente, selon une vue du dessus, une variante de réalisation du module photovoltaïque de la figure 16.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### DESCRIPTION DÉTAILLÉE DE L'INVENTION

Les figures 1 à 4 ont déjà été décrites précédemment dans la partie relative à l'état de la technique antérieure et au contexte technique de l'invention.

En référence aux figures 5 à 10, on va maintenant décrire des exemples de réalisation de structures photovoltaïques formant des modules précurseurs 15 obtenus par le biais d'un procédé de réalisation conforme à l'invention.

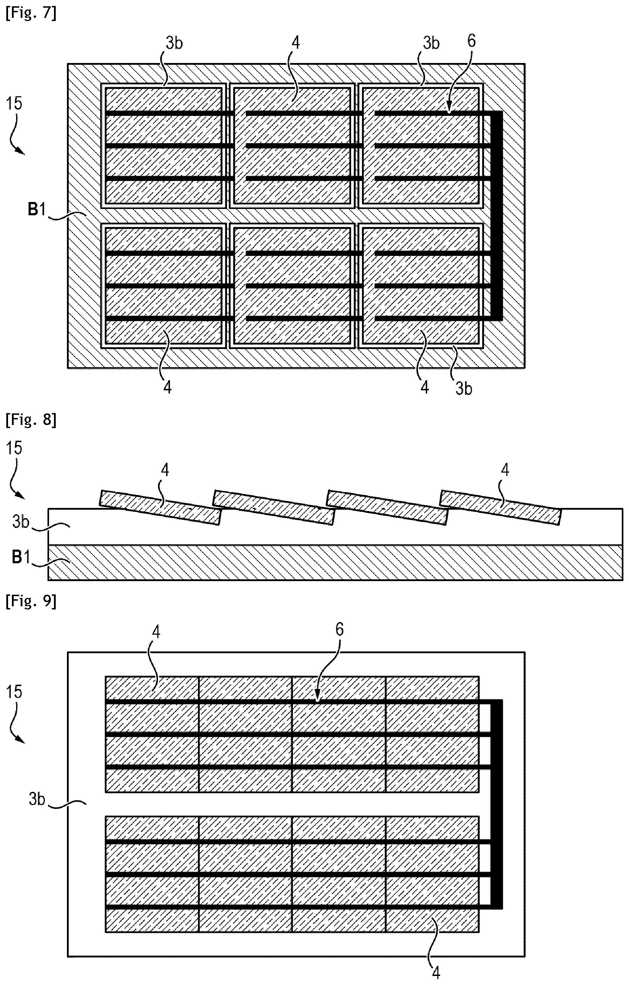

Plus précisément, les figures 5 à 7 sont relatives à une configuration de chaînes de cellules photovoltaïques 4 interconnectées par le biais de conducteurs de liaison 6, sous la forme de rubans ou de fils d'interconnexion, avec une alternance face avant et face arrière comme selon le principe décrit précédemment en référence à la figure 1. Les figures 8 à 10 sont quant à elles relatives à une configuration d'interconnexion en tuilage (« shingle » en anglais).

Ces figures 5 à 10 illustrent ainsi la lamination partielle mise en œuvre par le biais de la première étape de lamination à chaud du procédé de réalisation conforme à l'invention.

Ainsi, comme visible sur les figures 5 et 8, le module précurseur 15 est obtenu à partir d'un premier empilement comportant successivement, de haut en bas : une pluralité de cellules photovoltaïques 4 disposées côte à côte et reliées électriquement entre elles par des conducteurs de liaison 6, formant la face avant du module précurseur 15 ; une première couche de matériau d'encapsulation 3b, ou encore première couche d'adhésif ; et une première couche barrière B1, formant la face arrière du module précurseur 15. La première couche de matériau d'encapsulation 3b est donc située entre la pluralité de cellules photovoltaïques 4 et la première couche barrière B1.

Selon une première option représentée sur les figures 6 et 9, la première couche de matériau d'encapsulation 3b recouvre totalement la surface de la première couche barrière B1. Autrement dit, l'aire de la surface de la première couche de matériau d'encapsulation 3b est sensiblement égale à l'aire de la surface de la première couche barrière B1.

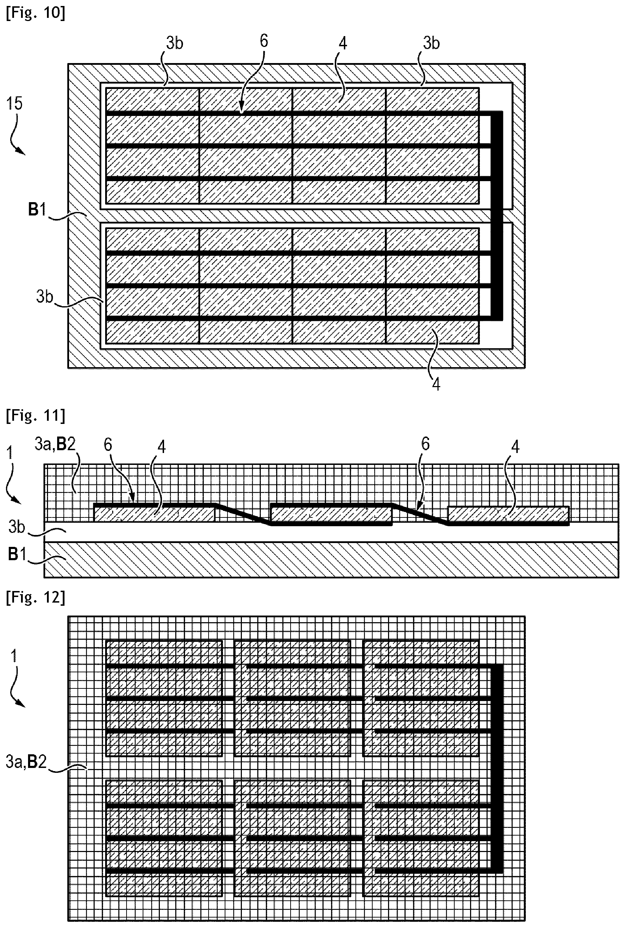

Selon une deuxième option représentée sur les figures 7 et 10, la première couche de matériau d'encapsulation 3b recouvre partiellement la surface de la première couche barrière B1. L'aire de la surface de la première couche de matériau d'encapsulation 3b est donc inférieure à l'aire de la surface de la première couche barrière B1. En particulier, la première couche de matériau d'encapsulation 3b recouvre uniquement sensiblement les zones de la surface de la première couche barrière B1 qui sont superposées aux cellules photovoltaïques 4 et/ou aux conducteurs de liaison 6.

Conformément à l'invention, le procédé de réalisation comporte alors une première étape de lamination à chaud des couches constitutives du premier empilement. Cette première étape de lamination à chaud est réalisée au moyen d'un dispositif de lamination 10, notamment tel que celui décrit auparavant en référence aux figures 3 et 4, au cours de laquelle le dispositif de lamination 10 est au contact direct des cellules photovoltaïques 4. Autrement dit, l'encapsulation n'est réalisée que d'un seul côté des cellules photovoltaïques 4. Celles-ci ne sont aucunement recouvertes du côté opposé à la première couche de matériau d'encapsulation 3b.

En particulier, lors de cette première étape de lamination à chaud, la membrane 11 du dispositif de lamination 10 vient au contact direct des cellules photovoltaïques 4. Le contact n'a avantageusement pas lieu avec une plaque de chauffage 12 du dispositif de lamination 10. Ainsi, il est possible de créer avec la membrane 11 un contact absorbant du côté non-encapsulé des cellules photovoltaïques 4 pour minimiser le risque de casse de celles-ci.

Le procédé de lamination est avantageusement adapté à l'encapsulant choisi, c'est-à-dire la première couche de matériau d'encapsulation 3b. En particulier, la première étape de lamination à chaud est réalisée à une température comprise entre 60°C et 180°C, et notamment comprise entre 120°C et 170°C. Autrement dit, la ou les plaques de chauffage sont à une température comprise entre 60°C et 180°C, et notamment comprise entre 120°C et 170°C.

L'épaisseur de la première couche de matériau d'encapsulation 3b peut être comprise entre 25 µm et 900 µm.

La première couche de matériau d'encapsulation 3b peut être formée par au moins une couche comportant au moins un matériau d'encapsulation de type polymère choisi parmi : les copolymères d'acides, les ionomères, le poly(éthylène-acétate de vinyle) (EVA), les acétals de vinyle, tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'α-oléfines et des α-, β- esters d'acide carboxylique à éthylénique, tels que les copolymères éthylène-acrylate de méthyle et les copolymères éthylène-acrylate de butyle, les élastomères de silicone et/ou les élastomères à base de polyoléfine thermoplastique réticulée, entre autres.

Les cellules photovoltaïques 4 sont préférentiellement des cellules de type silicium, autrement dit des cellules cristallines. Leur épaisseur peut être comprise entre 20 µm et 300 µm. Elles peuvent être interconnectées par différentes méthodes, par exemple soudure, brasure, adhésif électriquement conducteur (ou ECA pour « electrically conductive adhesive » en anglais), entre autres.

La première couche barrière B1 peut comporter un panneau en matériau composite, du verre, un matériau polymère et/ou un matériau composite à base de verre et de matériau polymère. Son épaisseur peut être comprise entre 12 µm et 6 cm.

Selon un mode de réalisation possible, la première couche barrière B1 peut être transparente, notamment aux longueurs d'ondes comprises entre 250 nm et 1800 nm, notamment entre 300 nm et 1200 nm.

La première couche barrière B1 peut en particulier comporter un panneau en matériau composite, comprenant une sous-couche principale, formant l'âme du panneau, et deux sous-couches de recouvrement, formant chacune une plaque du panneau, disposées de part et d'autre de l'âme de sorte que l'âme soit prise en sandwich entre les deux plaques, l'âme du panneau comportant une structure alvéolaire. Ce panneau peut présenter une épaisseur comprise entre 1 mm et 15 mm.

Le premier empilement peut, de manière optionnelle, comporter une première couche de renfort située entre la première couche barrière B1 et la première couche de matériau d'encapsulation 3b, notamment une première couche de renfort composite. Cette première couche de renfort composite peut présenter une densité massique comprise entre 20 g/m² et 500 g/m². Elle peut comporter une matrice thermodurcissable ou thermoplastique, ou encore un verre époxy.

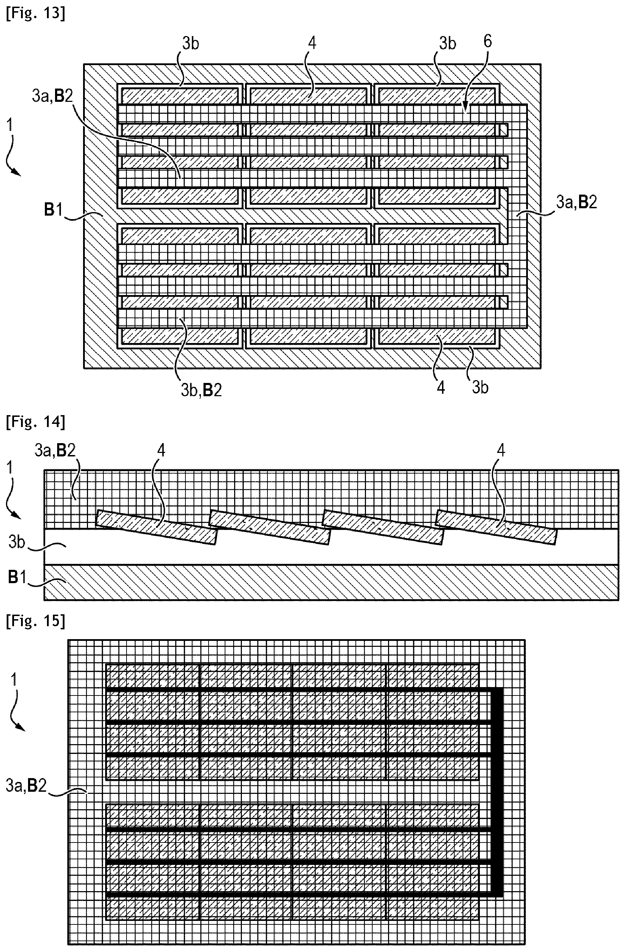

Par ailleurs, en référence aux figures 11 à 16, on va maintenant décrire l'obtention des modules photovoltaïques 1 à partir des modules précurseurs 15 des figures 5 à 10 par le biais d'un procédé de réalisation conforme à l'invention. Plus précisément, les figures 11 à 13 sont relatives à la configuration des figures 5 à 7. Les figures 14 à 16 sont relatives à la configuration des figures 8 à 10.

Ainsi, une deuxième étape d'assemblage à chaud est mise en œuvre pour l'obtention des modules photovoltaïques 1. Cette deuxième étape d'assemblage à chaud peut être de différents types. En particulier, il peut s'agir d'une deuxième étape de lamination, d'évaporation, d'impression, de vaporisation (ou « spray » en anglais), de raclage, d'enduction centrifuge (ou « spin coating » en anglais) et/ou de thermocompression, entre autres. Cette deuxième étape d'assemblage à chaud peut être réalisée par dépôt de film ou de matière. Elle peut être mise en œuvre à une température strictement supérieure à 0°C. Elle peut être réalisée avec ou sans variation de pression. Préférentiellement, et dans les exemples décrits ici, la deuxième étape d'assemblage à chaud est choisie pour être une deuxième étape de lamination à chaud.

Les figures 11 à 16 illustrent ainsi la lamination finale, qui peut être optionnelle, notamment pour le cas non souhaité d'une encapsulation totale des cellules photovoltaïques 4, mise en œuvre par le biais de la deuxième étape de lamination à chaud du procédé de réalisation conforme à l'invention. En particulier, pour certaines applications nécessitant un poids léger du module photovoltaïque ou dans le cas de cellules photovoltaïques suffisamment robustes, seule la première étape de lamination peut être mise en œuvre et le module précurseur 15 peut être utilisé en l'état plutôt que de constituer un produit intermédiaire dans la fabrication du module photovoltaïque 1.

Néanmoins, le plus souvent, la deuxième étape de lamination permet d'obtenir l'encapsulation complète du module précurseur 15 et donc des cellules photovoltaïques 4.

Ainsi, comme visible sur les figures 11 et 14, le module photovoltaïque 1 est obtenu à partir d'un deuxième empilement comportant successivement, de haut en bas : une deuxième couche de matériau d'encapsulation 3a ; et le module précurseur 15 obtenu précédemment au cours de la première étape de lamination.

Dans ces exemples, la deuxième couche de matériau d'encapsulation 3a forme la couche avant 2 transparente formant la face avant du module photovoltaïque 1, destinée à recevoir un flux lumineux, et alors la première couche barrière B1 forme la couche arrière 5 formant la face arrière du module photovoltaïque 1. A noter que cette couche arrière 5 peut également, dans certains modes de réalisation, par exemple dans le cas de cellules photovoltaïques bifaciales, être transparente et destinée à recevoir un flux lumineux. Autrement dit, la deuxième couche de matériau d'encapsulation 3a et la deuxième couche barrière B2 sont en un seul et même matériau. La deuxième couche de matériau d'encapsulation 3a et la deuxième couche barrière B2 sont donc confondues, il s'agit de la même couche.

Cependant, dans d'autres exemples de réalisation non représentés, le deuxième empilement peut comporter une deuxième couche barrière B2, distincte de la deuxième couche de matériau d'encapsulation 3a, autrement dit telle que la deuxième couche de matériau d'encapsulation 3a soit située entre la deuxième couche barrière B2 et la structure photovoltaïque 15. Alors, la deuxième couche barrière B2 peut former la couche avant 2 transparente formant la face avant du module photovoltaïque 1, destinée à recevoir un flux lumineux, et la première couche barrière B1 peut former la couche arrière 5 formant la face arrière du module photovoltaïque 1. A noter que cette couche arrière 5 peut également, dans certains modes de réalisation, par exemple dans le cas de cellules photovoltaïques bifaciales, être transparente et destinée à recevoir un flux lumineux.

Selon la première option représentée sur les figures 12 et 15, la deuxième couche de matériau d'encapsulation 3a recouvre totalement la surface de la première couche barrière B1. Autrement dit, l'aire de la surface de la deuxième couche de matériau d'encapsulation 3a est sensiblement égale à l'aire de la surface de la première couche barrière B1.

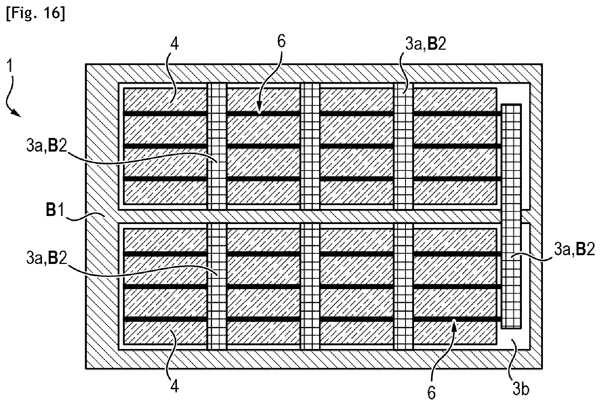

Selon la deuxième option représentée sur les figures 13 et 16, la deuxième couche de matériau d'encapsulation 3a recouvre partiellement la surface de la première couche barrière B1. L'aire de la surface de la deuxième couche de matériau d'encapsulation 3a est donc inférieure à l'aire de la surface de la première couche barrière B1. En particulier, la deuxième couche de matériau d'encapsulation 3a recouvre uniquement sensiblement les zones de la surface de la première couche barrière B1 qui sont superposées aux cellules photovoltaïques 4 et/ou aux conducteurs de liaison 6.

Conformément à l'invention, la deuxième étape de lamination à chaud des couches constitutives du deuxième empilement est réalisée afin d'obtenir les modules photovoltaïques 1. Cette deuxième étape de lamination à chaud est réalisée à une température qui peut être la température ambiante, par exemple autour de 20°C, ou une température inférieure à la température de la première étape de lamination à chaud, notamment à une température comprise entre 50°C et 100°C, notamment à une température inférieure à la température de la première étape de lamination minorée de 30°C, notamment comprise entre 50°C et 100°C. En particulier, le dispositif de lamination 10 comporte au moins une plaque de chauffage 12 à une température comprise entre 50°C et 100°C. Lors de cette étape, la membrane 11 du dispositif de lamination 10 vient au contact direct de la deuxième couche barrière B2 et/ou de la deuxième couche de matériau d'encapsulation 3a lorsque celle-ci est confondue avec la deuxième couche barrière B2.

Un primaire d'adhésion peut être ajouté au contact de la deuxième couche de matériau d'encapsulation 3a, notamment de part et d'autre de la deuxième couche de matériau d'encapsulation 3a.

Alors, la deuxième couche de matériau d'encapsulation 3a forme une couche avant de matériau d'encapsulation et la première couche de matériau d'encapsulation 3b forme une couche arrière de matériau d'encapsulation, réunies entre elles pour définir un ensemble encapsulant 3 la pluralité de cellules photovoltaïques 4.

Optionnellement, le deuxième empilement peut comporter une deuxième couche de renfort située entre la deuxième couche barrière B2, lorsqu'elle est présente, et la deuxième couche de matériau d'encapsulation 3a, notamment une deuxième couche de renfort composite. Cette deuxième couche de renfort composite peut présenter une densité massique comprise entre 20 g/m² et 500 g/m². Elle peut comporter une matrice thermodurcissable ou thermoplastique, ou encore un verre époxy.

Avantageusement, la deuxième couche de matériau d'encapsulation 3a comporte du silicone liquide et/ou un film adhésif. Son épaisseur est comprise entre 12 µm et 200 µm.

La première couche barrière B1 et/ou la deuxième couche barrière B2 peuvent comporter du verre, présentant notamment une épaisseur comprise entre 30 µm et 500 µm.

En variante, la première couche barrière B1 et/ou la deuxième couche barrière B2 peuvent comporter un matériau polymère, présentant notamment une épaisseur comprise entre 12 µm et 500 µm.

En variante encore, la première couche barrière B1 et/ou la deuxième couche barrière B2 peuvent comporter un matériau composite à base de verre et de matériau polymère, présentant notamment une épaisseur comprise entre 12 µm et 500 µm.

Le matériau polymère peut être choisi parmi : le polycarbonate (PC), le polyuréthane (PU), le polypropylène (PP), l'époxy, le polyimide (PI), le polyétheréthercétone (PEEK), le polyméthacrylate de méthyle (PMMA), le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), le polychlorotrifluoroéthylène (PCTFE), l'éthylène propylène fluoré (FEP) et/ou un film multicouche comprenant un ou plusieurs des polymères précités, entre autres.

Selon une réalisation privilégiée, le deuxième empilement comporte une deuxième couche barrière B2 sous la forme d'une couche polymère fluorée, une première couche de primaire d'adhésion, une deuxième couche de matériau d'encapsulation 3a sous la forme d'un adhésif silicone liquide ou sous forme de film adhésif, une deuxième couche de primaire d'adhésion, et le premier empilement comprenant la pluralité de cellules photovoltaïques 4 de type silicium, une première couche de matériau d'encapsulation 3b sous la forme d'un film adhésif EVA et une première couche barrière B1 sous la forme d'un panneau comprenant une structure sandwich avec un nid d'abeilles.

De manière avantageuse, l'invention permet donc l'utilisation d'un module précurseur 15 qui repose sur le principe d'une lamination partielle. Une première étape de lamination est réalisée sur un module incomplet pour obtenir le module précurseur 15 qui n'est alors encapsulé que sur une face. Une deuxième étape d'assemblage peut alors permettre de finaliser l'encapsulation et d'obtenir le module photovoltaïque 1.

Avantageusement, l'invention peut permettre d'utiliser des matériaux, notamment des encapsulants, avec des températures, des propriétés et des procédés de mise en œuvre différents, notamment qui diffèrent pour la face avant et pour la face arrière. La lamination peut être optimisée pour les couches de la face avant ou de la face arrière du module par le biais d'un optimum de séquence température, pression, durée. Une approche modulaire peut être adoptée par la fabrication de modules précurseurs qui peuvent s'adresser à différentes applications en fonction des choix d'encapsulation effectués, notamment lors de la deuxième étape d'assemblage. L'invention peut également permettre de faciliter le stockage et la manipulation des chaînes de cellules photovoltaïques qui peuvent être laminés en modules précurseurs. La réalisation d'une encapsulation en deux étapes peut aussi permettre un meilleur contrôle du stress résiduel dans l'empilement du module photovoltaïque. En outre, un gain de masse du module photovoltaïque peut être obtenu par une dissymétrie dans les choix des matériaux et procédés utilisés pour les faces avant et arrière.

Bien entendu, l'invention n'est pas limitée aux exemples de réalisation qui viennent d'être décrits. Diverses modifications peuvent y être apportées par l'homme du métier.

## Revendications

1. Procédé de réalisation d'une structure photovoltaïque (15), définissant un module précurseur, à partir d'un premier empilement comportant :
- une pluralité de cellules photovoltaïques (4) disposées côte à côte et reliées électriquement entre elles par des conducteurs de liaison (6), formant la face avant de la structure photovoltaïque (15),
- une première couche de matériau d'encapsulation (3b),
- une première couche barrière (B1), formant la face arrière de la structure photovoltaïque (15),
la première couche de matériau d'encapsulation (3b) étant située entre la pluralité de cellules photovoltaïques (4) et la première couche barrière (B1),
**caractérisé en ce que** le procédé comporte une première étape de lamination à chaud des couches constitutives du premier empilement au moyen d'un dispositif de lamination (10), au cours de laquelle le dispositif de lamination (10) est au contact direct des cellules photovoltaïques (4).

2. Procédé selon la revendication 1, dans lequel le dispositif de lamination (10) comporte une membrane (11) venant au contact direct des cellules photovoltaïques (4) lors de la première étape de lamination à chaud.

3. Procédé selon la revendication 1 ou 2, dans lequel la première étape de lamination à chaud est réalisée à une température comprise entre 60°C et 180°C, notamment comprise entre 120°C et 170°C.

4. Procédé selon l'une des revendications précédentes, dans lequel la première couche de matériau d'encapsulation (3b) recouvre totalement la surface de la première couche barrière (B1).

5. Procédé selon l'une des revendications 1 à 3, dans lequel la première couche de matériau d'encapsulation (3b) recouvre partiellement la surface de la première couche barrière (B1), recouvrant notamment uniquement les zones de la surface de la première couche barrière (B1) superposées aux cellules photovoltaïques (4) et/ou aux conducteurs de liaison (6).

6. Procédé de réalisation d'un module photovoltaïque (1) à partir d'un deuxième empilement comportant :
- une deuxième couche de matériau d'encapsulation (3a),
- une structure photovoltaïque (15) obtenue par le procédé de réalisation selon l'une quelconque des revendications précédentes,
**caractérisé en ce que** le procédé comporte une deuxième étape d'assemblage à chaud des couches constitutives du deuxième empilement.

7. Procédé selon la revendication 6, dans lequel la deuxième couche de matériau d'encapsulation (3a) forme l'une d'une couche avant (2) transparente formant la face avant du module photovoltaïque (1), destinée à recevoir un flux lumineux, et d'une couche arrière (5) formant la face arrière du module photovoltaïque (1), et dans lequel la première couche barrière (B1) forme l'autre de ladite couche avant (2) et de ladite couche arrière (5).

8. Procédé selon la revendication 6, dans lequel le deuxième empilement comporte encore une deuxième couche barrière (B2), la deuxième couche de matériau d'encapsulation (3a) étant située entre la deuxième couche barrière (B2) et la structure photovoltaïque (15), la deuxième couche barrière (B2) formant notamment l'une d'une couche avant (2) transparente formant la face avant du module photovoltaïque (1), destinée à recevoir un flux lumineux, et d'une couche arrière (5) formant la face arrière du module photovoltaïque (1), et la première couche barrière (B1) formant notamment l'autre de ladite couche avant (2) et de ladite couche arrière (5).

9. Procédé selon l'une des revendications 6 à 8, dans lequel la deuxième étape d'assemblage à chaud comporte une deuxième étape de lamination à chaud.

10. Procédé selon l'une quelconque des revendications 6 à 9, dans lequel la deuxième étape d'assemblage à chaud est réalisée à température ambiante.

11. Procédé selon l'une quelconque des revendications 6 à 10, dans lequel la deuxième étape d'assemblage à chaud est réalisée à une température inférieure à la température de la première étape de lamination minorée de 30°C, notamment comprise entre 50°C et 100°C.

12. Procédé selon l'une quelconque des revendications 6 à 11, dans lequel la première couche de matériau d'encapsulation (3b) et/ou la deuxième couche de matériau d'encapsulation (3a) sont formées par au moins une couche comportant au moins un matériau d'encapsulation de type polymère choisi parmi : les copolymères d'acides, les ionomères, le poly(éthylène-acétate de vinyle) (EVA), les acétals de vinyle, tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'α-oléfines et des α-, β- esters d'acide carboxylique à éthylénique, tels que les copolymères éthylène-acrylate de méthyle et les copolymères éthylène-acrylate de butyle, les élastomères de silicone et/ou les élastomères à base de polyoléfine thermoplastique réticulée.

13. Procédé selon l'une quelconque des revendications 6 à 11, dans lequel la première couche de matériau d'encapsulation (3b) et/ou la deuxième couche de matériau d'encapsulation (3a) comportent du silicone liquide et/ou un film adhésif.

14. Procédé selon l'une quelconque des revendications 6 à 13, dans lequel la première couche de matériau d'encapsulation (3b) et/ou la deuxième couche de matériau d'encapsulation (3a) présentent une épaisseur comprise entre 12 µm et 900 µm, notamment entre 25 µm et 900 µm.

15. Procédé selon l'une quelconque des revendications 8 à 14, dans lequel la première couche barrière (B1) et/ou la deuxième couche barrière (B2) comportent un panneau en matériau composite, du verre, un matériau polymère et/ou un matériau composite à base de verre et de matériau polymère.

16. Procédé selon la revendication 15, dans lequel le matériau polymère est choisi parmi : le polycarbonate (PC), le polyuréthane (PU), le polypropylène (PP), l'époxy, le polyimide (PI), le polyétheréthercétone (PEEK), le polyméthacrylate de méthyle (PMMA), le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), le polychlorotrifluoroéthylène (PCTFE), l'éthylène propylène fluoré (FEP) et/ou un film multicouche comprenant un ou plusieurs des polymères précités.
